# EUROPEAN PATENT APPLICATION

(11) **EP 3 702 490 A2**
(43) Date of publication of application: **02.09.2020**
(21) Application number: 20159636.8
(22) Date of filing: 26.02.2020
(51) Int. Cl.: C23C 14/24, C04B 35/83

(54) **DESPOSITION SOURCE EVAPORATING APPARATUS**

(30) Priority: 27.02.2019 KR 20190023286
(71) Applicant: Samsung Display Co., Ltd., Gyeonggi-do 17113 (KR)
(72) Inventor: AN, Byounggu, 17113 Gyeonggi-Do (KR); KIM, Kyunghan, 17113 Gyeonggi-Do (KR); CHA, Mincheol, 17113 Gyeonggi-Do (KR); PARK, Jaemork, Gyeonggi-do (KR); CHO, Wonseok, Gyeonggi-do (KR); JUNG, Kichae, Gyeonggi-do (KR); CHO, Yunhyung, Gyeonggi-do (KR)
(74) Representative: Taor, Simon Edward William

(57) **Abstract**

A deposition source evaporating apparatus includes a crucible set for accommodating a deposition source, a spray unit positioned on the crucible set, a heater positioned in the crucible set for heating the crucible set to evaporate the deposition source through the spray unit, and a heat radiation preventing plate surrounding the spray unit for blocking radiation of heat at a side of the spray unit. At least one of the crucible unit and the heat radiation preventing plate includes a carbon fiber composite material.

## Description

### BACKGROUND

### 1. Field

The technical field relates to an apparatus for evaporating a deposition source in a deposition operation.

### 2. Description of the Related Art

In a process of manufacturing a thin film, such as a thin film of an organic light-emitting display device, a deposition operation may be performed. In the deposition operation, a deposition source is evaporated for enabling material to adhere to a substrate surface. A mask may be placed on the substrate, and vapor of the material may pass through one or more openings of the mask to form a thin film of a desired pattern on the substrate.

### SUMMARY

According to embodiments, a temperature may be in a range 1100 degrees Celsius to 1300 degrees Celsius during evaporation of a deposition source, and an evaporation apparatus may reliably and continuously perform evaporation at the high temperature for producing a satisfactory amount of thin films. Advantageously, quality of deposition may be optimized, and production efficiency for thin films may be optimized.

Embodiments may be related to a deposition source evaporating apparatus. The apparatus may be capable of performing a deposition operation at a high temperature for a long time.

According to one or more embodiments, the deposition source evaporating apparatus includes a crucible unit accommodating a deposition source and having a spray unit on one side, a heater heating the crucible unit to evaporate the deposition source through the spray unit, and a heat radiation preventing plate suppressing a heat radiation through a side of the spray unit, wherein a material of any one of the crucible unit and the heat radiation preventing plate includes a carbon fiber composite.

The carbon fiber composite may include a material obtained by compressing and hardening a result of mixing a carbon fiber granule with a first carbon-based resin.

The carbon fiber granule may include any one of a chopped fragment or ground powder of carbon fiber.

An internal gap of the carbon fiber composite may be filled with a second carbon-based resin by being impregnated with the second carbon-based resin and then being hardened.

The heat radiation preventing plate may be a single body.

The crucible unit may include an inner crucible accommodating the deposition source, an outer crucible accommodating the inner crucible and heated by the heater, a housing accommodating the outer crucible and the heater, and a cooling jacket accommodating the housing and having a coolant circulation unit, and a material of the inner crucible, the outer crucible, and the housing includes the carbon fiber composite.

The inner crucible may be a single body having a single accommodating space.

An internal wall of the housing may be installed with a heat radiation plate including the carbon fiber composite.

The housing, the heat radiation plate, and the outer crucible may be an integral body.

The deposition source evaporating apparatus may include a pair of the crucible units in which the spray units are symmetrically arranged, and pair of heaters and a pair of heat radiation preventing plates respectively installed in the crucible units.

An embodiment may be related to a deposition source evaporating apparatus. The apparatus may include the following elements: a first crucible set for accommodating a deposition source; a spray unit positioned on the first crucible set; a heater positioned in the first crucible set for heating the first crucible set to evaporate the deposition source through the spray unit; and a heat radiation preventing plate surrounding the spray unit for suppressing/blocking heat radiation at a side of the first crucible set. At least one of the first crucible set and the heat radiation preventing plate comprises a carbon fiber composite material.

The carbon fiber composite material may include a carbon fiber granule and a first carbon-based resin.

The carbon fiber granule may include at least one of a carbon fiber fragment and carbon fiber powder.

An internal gap of the carbon fiber composite material may be filled with a second carbon-based resin.

The heat radiation preventing plate may be a single body. A length of the single body may be greater than a half of the length of the apparatus.

The first crucible set may include an inner crucible for accommodating the deposition source, an outer crucible accommodating the inner crucible and configured to transfer heat from the heater to the inner crucible, a housing accommodating the outer crucible and the heater, a cooling jacket accommodating the housing, and a coolant circulation unit positioned on the cooling jacket. At least one of the inner crucible, the outer crucible, and the housing may include the carbon fiber composite material.

The inner crucible may be a single body having a single accommodating space. A length of the single accommodating space may be greater than a half of the length of the apparatus.

The crucible set further may include a heat radiation plate positioned on an internal wall of the housing. The heat radiation plate may include the carbon fiber composite material.

The housing, the heat radiation plate, and the outer crucible may be an integral body of a same material.

The apparatus may include the following elements: a first plurality of spray units positioned on the first crucible set and including the spray unit; a second crucible set; and a second plurality of spray units positioned on the second crucible set and being a mirror image of the first plurality of spray units.

According to an aspect, there is provided a deposition source evaporating apparatus as set out in claim 1. Additional features of this aspect are set out in claims 2 to 12.

### BRIEF DESCRIPTION OF THE DRAWINGS

FIG. 1 is a diagram illustrating a deposition operation using a deposition source evaporating apparatus according to an embodiment.
FIG. 2 is a perspective view of the deposition source evaporating apparatus shown in FIG. 1 according to an embodiment.
FIG. 3 is a disassembled (or exploded) perspective view of the deposition source evaporating apparatus shown in FIG. 2 according to an embodiment.
FIG. 4A is a flowchart of steps in a manufacturing method of the deposition source evaporating apparatus shown in FIG. 2 according to an embodiment, and FiG. 4B is an image of carbon fiber fragment and carbon fiber powder according to an exemplary embodiment.
FIG. 5A and FIG. 5B are schematic views illustrating a vacuum exhaust operation and an impregnation operation in the manufacturing of a deposition source evaporating apparatus according to an embodiment.
FIG. 6 is a disassembled perspective view illustrating a deposition source evaporating apparatus according to an embodiment.
FIG. 7 is a perspective view illustrating a deposition source evaporating apparatus according to an embodiment.
FIG. 8 is a cross-sectional view illustrating a target substrate shown in FIG. 1 according to an embodiment.

### DETAILED DESCRIPTION

Example embodiments are described with reference to the accompanying drawings. Like reference numerals may refer to like elements. Practical embodiments may have different forms and should not be construed as being limited to the descriptions set forth herein.

In the descriptions, an expression used in the singular may encompass the expression of the plural.

The terms such as "including," "having," and "comprising" may indicate the existence of the stated features or components and may not preclude the possibility that one or more other features or components may be included.

Sizes of components in the drawings may be exaggerated for convenience of explanation.

When a certain embodiment may be implemented differently, a specific process order may be performed differently from the described order. For example, two consecutively described processes may be performed substantially at the same time or performed in an order opposite to the described order.

Although the terms "first," "second," etc. may be used to describe various elements, these elements, should not be limited by these terms. These terms may be used to distinguish one element from another element. A first element may be termed a second element without departing from teachings of one or more embodiments. The description of an element as a "first" element may not require or imply the presence of a second element or other elements. The terms "first," "second," etc. may be used to differentiate different categories or sets of elements. For conciseness, the terms "first," "second," etc. may represent "first-type (or first-set)," "second-type (or second-set)," etc., respectively.

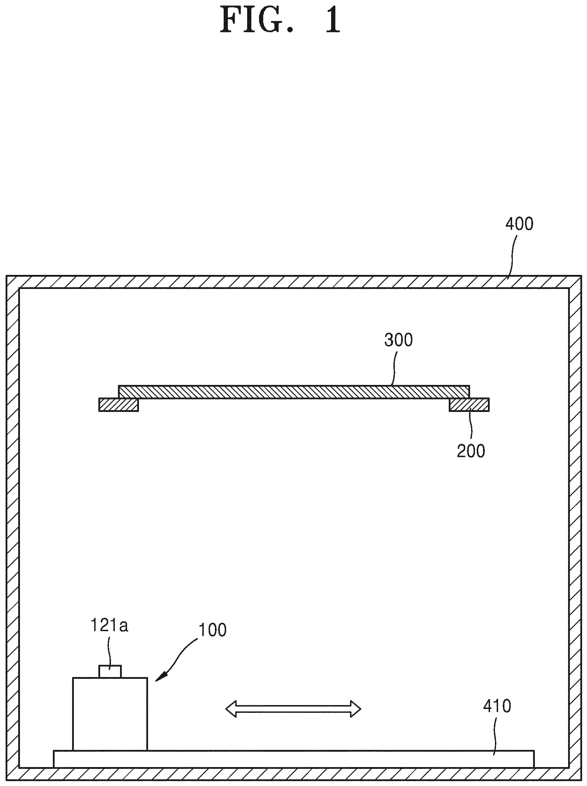

FIG. 1 schematically illustrates a structure of a thin film deposition apparatus using a deposition source evaporating apparatus 100 according to an embodiment.

As shown in FIG. 1, the thin film deposition apparatus includes a mask 200 limiting a deposition region on a target substrate 300 and includes the deposition source evaporating apparatus 100 for spurting/providing a deposition gas towards the target substrate 300 in a chamber 400.

When the deposition source evaporating apparatus 100 inside the chamber 400 spurts/provides the deposition gas through a spray unit 121a, the deposition gas passes through an opening of the mask 200 and adheres to the target substrate 300 to form a thin film having a (predetermined) pattern.

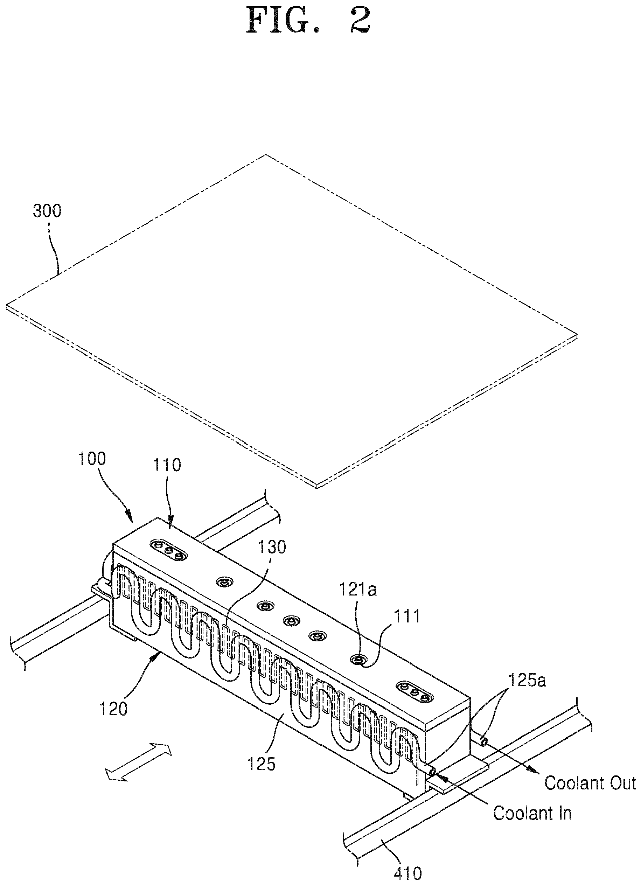

Referring to FIGS. 1 and 2, the deposition source evaporating apparatus 100 reciprocates in the chamber 400 along a rail 410 and sprays the deposition gas over an entire deposition region of the target substrate 300. In an embodiment, the deposition source evaporating apparatus 100 may be configured to perform deposition in a fixed state while the target substrate 300 reciprocates or rotates. Various changes may be made as to which of the deposition source evaporating apparatus 100 and the target substrate 300 is to be fixed and which is to be moved to achieve relative movement.

Referring to FIG. 2, the deposition source evaporating apparatus 100 includes a crucible unit 120 (or crucible set 120) for accommodating (or containing) a deposition source and for spraying a deposition gas towards the target substrate 300 through the spray unit 121a, a heater 130 for heating the crucible unit 120 to evaporate the deposition source, and a heat radiation preventing plate 110 surrounding the spray unit 121a for preventing heat generated in the crucible unit 120 from being emitted towards the target substrate 300. When the heater 130 heats the crucible unit 120, the deposition source accommodated in the crucible unit 120 is evaporated and spurted through the spray unit 121a. The heater 130 has a structure including three sections 130a, 130b, and 130c, and a differential heating control for each section is possible.

Reference numeral 111 refers to a through hole formed in the heat radiation preventing plate 110 in correspondence with the spray unit 121a. Reference numeral 125 refers to a cooling jacket 125 having a coolant circulation unit 125a in the crucible unit 120; the cooling jacket 125 is provided to properly cool the surroundings of the heater 130 such that the surroundings are not overheated by the heater 130.

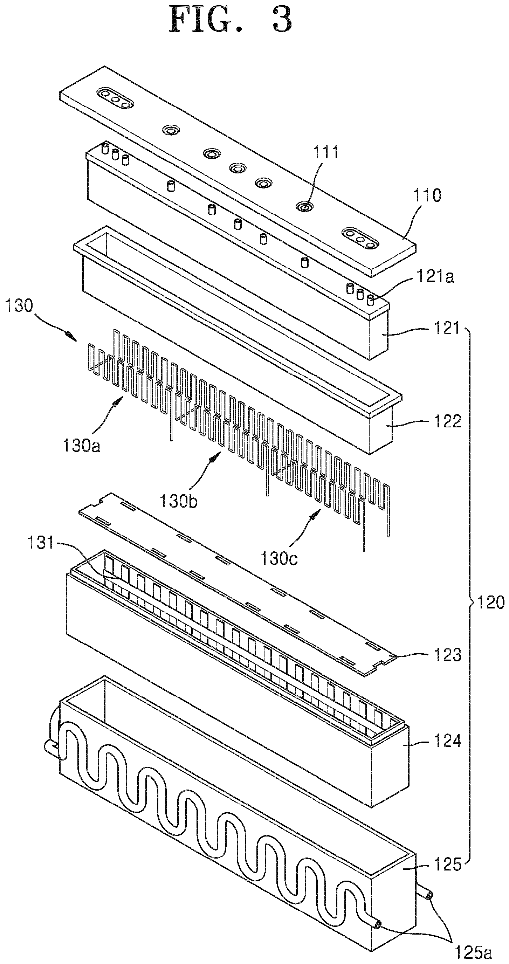

As shown in FIG. 3, the crucible unit 120 includes an inner crucible 121 and an outer crucible 122, a heat radiation plate 123, a housing 124, and the cooling jacket 125.

The inner crucible 121 directly accommodates the deposition source in an inner space of the inner crucible 121. When the accommodated deposition source is exhausted, the inner crucible 121 is taken out from the crucible unit 120, replacement deposition source is filled in the inner/accommodating space of the inner crucible 121, and then the inner crucible 121 is reinstalled to be used.

The outer crucible 122 contains the inner crucible 121, and the heater 130 is installed on an outer wall of the outer crucible 122 to provide heat though the outer crucible 122 to the inner crucible 121.

The housing 124 contains the outer crucible 122 and the heater 130, and the heat radiation plate 123 is arranged on an inner bottom surface of the housing 124. The heat radiation plate 123 protects the housing 124 from being deformed by the heat of the heater 130. One or more additional or alternative heat radiation plates 123 may be provided on a side surface and/or an outer surface of the housing 124. In an embodiment, a frame (not shown) may be installed on the bottom surface of the housing 124 to support the heat radiation plate 123. Reference numeral 131 refers to an insulator which maintains a gap such that the heater 130 does not directly contact an inner wall of the housing 124.

The cooling jacket 125 contains the housing 124 and may properly cool the housing 124 with coolant circulating through the coolant circulation unit 125a installed on an outer wall of the cooling jacket 125.

In an embodiment, the heat radiation preventing plate 110, the inner crucible 121 and the outer crucible 122, and the housing 124 are each formed as a single body instead of as a divided body. For example, a body of the heat radiation preventing plate 110 is not divided into several portions but is formed as one entire body. The inner crucible 121 is also formed as a single body having a single accommodating space, and likewise, the outer crucible 122, the heat radiation plate 123, and the housing 124 are each formed as a single body.

In comparative examples, the above-described components may not be formed as a single body but may be formed by forming several separate portions and then attaching the portions together for use. The reason is that a possibility of thermal deformation is increased when the above-described components are formed as a single body. Since the heat radiation preventing plate 110 and the housing 124 receive heat from the heater 130 in a deposition operation at a temperature over 1000 degrees Celsius for a long time, there is a concern about thermal deformation, and in particular, there may be a higher possibility of deformation such as twisting when the members are large and long. Therefore, in comparative examples, the members are made small and short and then attached together for use to reduce the risk of such deformation. In comparative examples, a gap may be formed in a region where various pieces of the heat radiation preventing plate 110 meet and heat of a high temperature is released to the outside through each gap; the configuration may increase the risk of deterioration of the target substrate 300 or surrounding equipment due to heat. In terms of workability, there are considerable disadvantages in that the manufacturing process becomes complicated since an additional assembling operation, in which members are attached together after being made as individual bodies, needs to be carried out.

In an embodiment, as the heat radiation preventing plate 110, the inner crucible 121, the outer crucible 122, and the housing 124 are each formed as a single body, problems of such heat radiation leakage or complicated manufacturing operation may be prevented.

The reason why the members may be formed as a single body is that the material for forming the members has been improved by a carbon fiber composite. A carbon fiber composite has excellent heat resistance and may withstand a temperature over around 1300 degrees Celsius for a long time without deformation.

The heat radiation preventing plate 110 may be basically prepared as a single body (or monolithic body) formed of a carbon fiber composite material to prevent gaps in a body of the heat radiation preventing plate 110 where there is a risk of heat leakage, and a simple production operation that does not require attaching of multiple pieces is implemented.

The inner crucible 121, the outer crucible 122, the heat radiation plate 123, the housing 124, and a frame (not shown) supporting the heat radiation plate 123 inside the housing 124 may all be formed as a single body using the above-described carbon fiber composite material. Even when a deposition operation of high temperature is continued for a long time, a highly stable operating environment (in which there is no risk such as thermal deformation of the members themselves or heat leakage to the outside) may be realized; thus, both workability and product quality may be improved.

The deposition source evaporating apparatus 100 may be used for deposition of various thin films, for example, to form a metal electrode layer or an organic/inorganic film of an organic light-emitting display device.

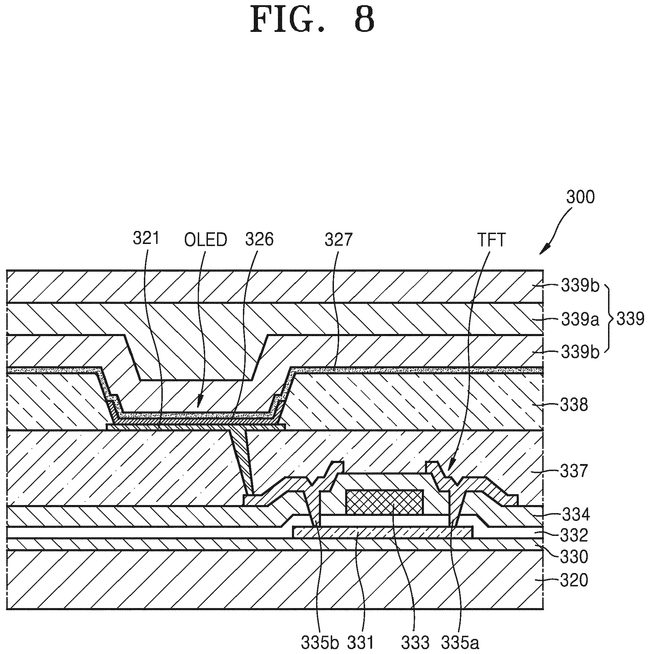

FIG. 8 illustrates a structure of an organic light-emitting display device as an example of the target substrate 300 on which a thin film may be deposited using the deposition source evaporating apparatus 100.

Referring to FIG. 8, a buffer layer 330 is formed on a base plate 320, and a thin film transistor (TFT) is provided on the buffer layer 330.

The TFT includes an active layer 331, a gate insulating film 332 formed to cover the active layer 331, and a gate electrode 333 on the gate insulating film 332.

An interlayer insulating film 334 is formed to cover the gate electrode 333, and a source electrode 335a and a drain electrode 335b are formed on the interlayer insulating film 334.

The source electrode 335a and the drain electrode 335b are respectively in contact with a source region and a drain region of the active layer 331 through contact holes formed in the gate insulating film 332 and the interlayer insulating film 334.

A pixel electrode 321 of an organic light-emitting diode OLED is connected to the drain electrode 335b. The pixel electrode 321 is formed on a planarizing film 337, and a pixel defining layer 338 defining a sub-pixel region is formed on the pixel electrode 321. A light-emitting layer 326 of the organic light-emitting diode OLED is formed in an opening of the pixel defining layer 338, and an opposite electrode 327 is deposited thereon. The opening surrounded by the pixel defining layer 338 is a region of one sub-pixel region such as a red pixel R, a green pixel G, or a blue pixel B, and the light-emitting layer 326 of a corresponding color is formed in the opening. A thin film encapsulation layer 339 in which an organic film 339a and an inorganic film 339b are alternately stacked may be formed on the opposite electrode 327.

The organic film 339a and the inorganic film 339b of the thin film encapsulation layer 339 and/or the opposite electrode 327 (which is a metal layer) may be formed by the deposition source evaporating apparatus 100 (which includes components formed of the carbon fiber composite material).

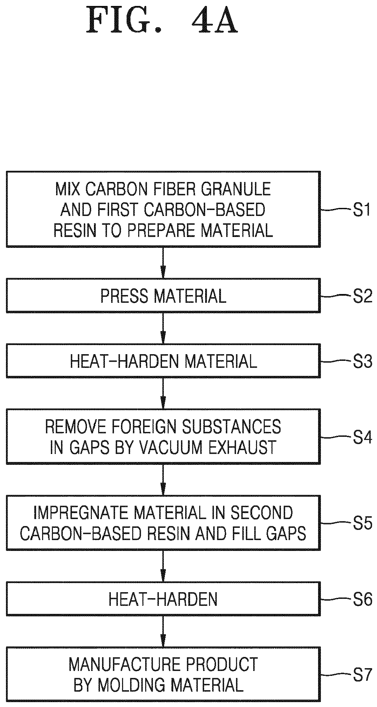

The manufacturing operation of the members of the deposition source evaporating apparatus 100 using the above-described carbon fiber composite may be performed according to the flowchart shown in FIG. 4A.

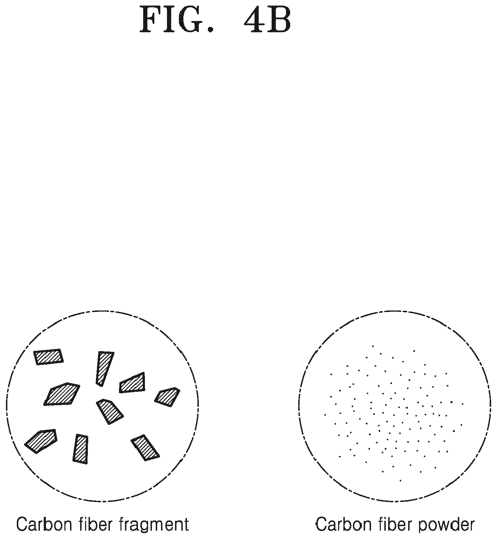

First, the carbon fiber composite used as a material for forming the members may be prepared by mixing carbon fiber granules and a first carbon-based resin (S1). The carbon fiber granules may be/include chopped fragments and/or ground powder, which may be mixed with the first carbon-based resin to produce a material in a paste state (refer to Fig. 4B). Subsequently, the material in the paste state is pressed by a press (S2) and is heated to be hardened (S3). Then, a material in a solid state is obtained. In this state, there are a large number of gaps inside the material and foreign substances are considerably filled in the gaps, and thus the strength of the material resulted from the step S3 may be insufficient for the members of the deposition source evaporating apparatus 100.

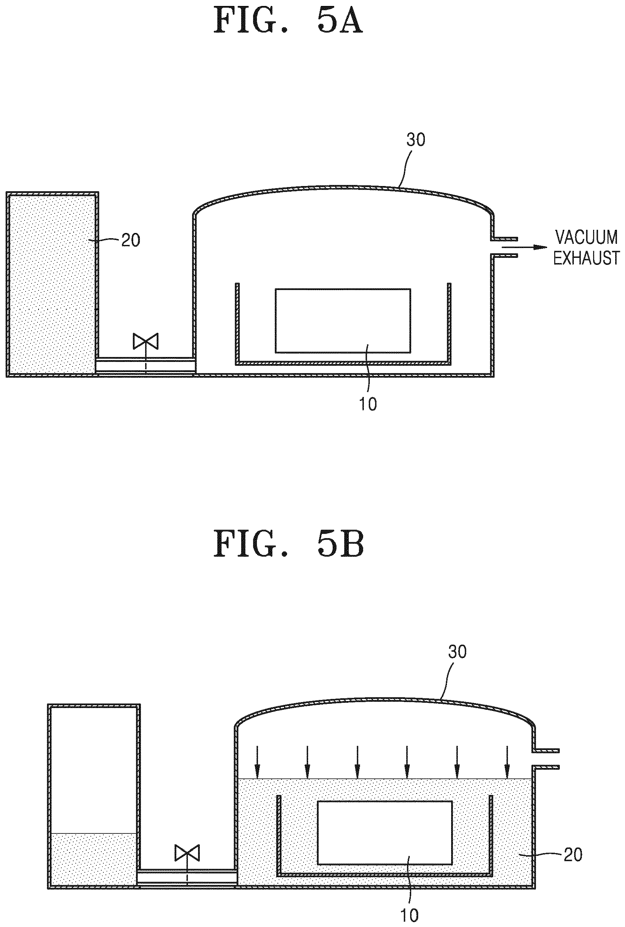

Therefore, the foreign substances are removed by a vacuum exhaust (S4), and the gaps are filled with a second carbon-based resin (S5). Referring to FIG. 5A, in a vacuum exhausting operation, a material 10 (resulted from the step S3) is placed in an operational tank 30, and vacuum exhausting is performed such that the foreign substances filled in internal gaps in the material 10 are removed by vacuum pressure. Subsequently, referring to FIG. 5B, the second carbon-based resin 20 is supplied to the operational tank 30 to impregnate the material 10. Then, the second carbon-based resin 20 permeates and fills the gaps where the foreign substances are removed. The second carbon-based resin 20 may be of the same as or different from the first carbon-based resin.

After the step S5, the material 10 is heated again and hardened, the second carbon-based resin 20 filled in the gaps is hardened and becomes integral with a main body of the material 10.

The material resulted from the step S6 has very high heat resistance and proper strength for forming the members of the deposition source evaporating apparatus 100. The material is molded to form the heat radiation preventing plate 110, the inner crucible 121, the outer crucible 122, the heat radiation plate 123, and the housing 124 (S7). Even when a deposition operation of high temperature is continued for a long time, a highly stable operation environment (in which there is no risk such as the thermal deformation of the members themselves or heat leakage to the outside) may be realized.

The cooling jacket 125 may also include a/the carbon fiber composite. The cooling jacket 125 may include the coolant circulation unit 125a and may serve as an outermost protection wall of the crucible unit 120. The cooling jacket 125 may require a higher impact resistance than heat resistance. Therefore, the cooling jacket 125 may alternatively or additionally include stainless steel. The heater 130 may include a material such as Ta and W, and the insulator 131 may include a material in which AIN and BN are mixed. The cooling jacket 125, the heater 130, and the insulator 131 may or may not include the carbon fiber composite. The heat radiation preventing plate 110, the inner crucible 121 and the outer crucible 122, the heat radiation plate 123, and the housing 124 may be formed of the carbon fiber composite to ensure a strong heat resistance.

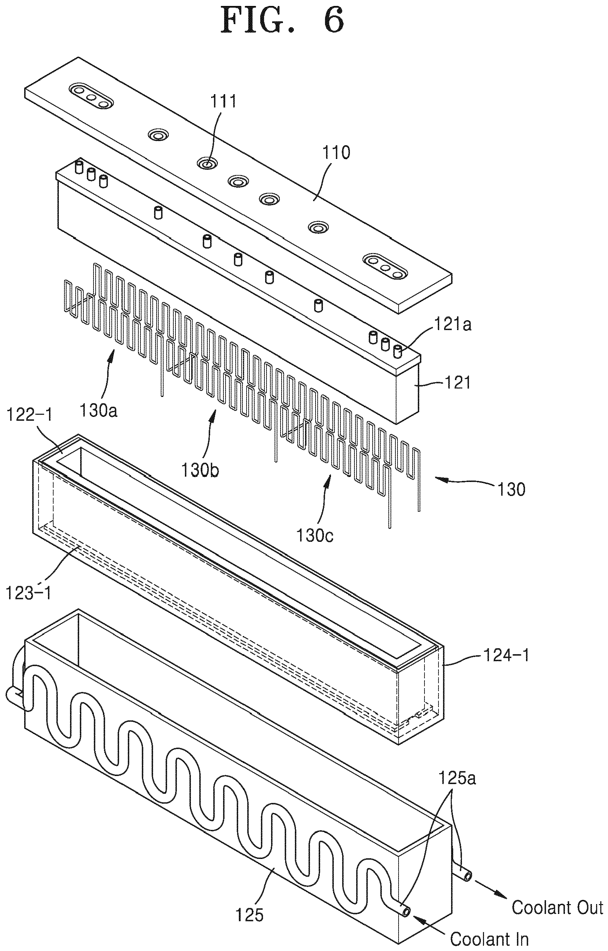

FIG. 6 illustrates a structure in which an outer crucible 122-1, a housing 124-1, and a heat radiation plate 123-1 are integrally formed. The members are combined as a single body to reduce a number of the members. The single body may be formed of the carbon fiber composite to provide a strong heat resistance and thus to withstand thermal deformation.

The heat radiation plate 123-1 may be a single layer or may include a plurality of stacked layers to enhance the heat radiation effects.

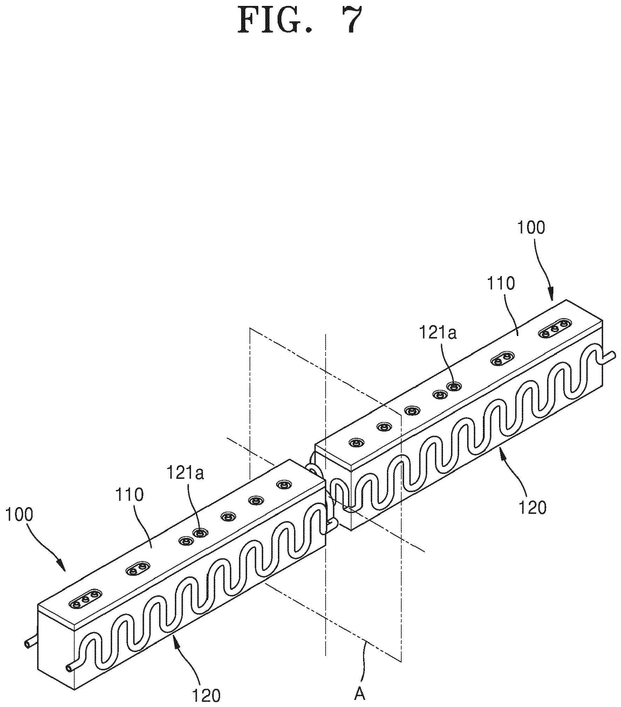

FIG. 7 illustrates a configuration suitable for a large target substrate 300. When deposition is required on the target substrate 300 having a large size exceeding a range that may be handled by one deposition source evaporating apparatus 100, a pair of deposition source evaporating apparatuses 100 (each including a crucible unit 120, a heat radiation preventing plate 110, and a heater 130) may be configured as shown in FIG. 7. The spray units 121a may be symmetrical to each other with respect to a geometric plane A between the deposition source evaporating apparatuses 100. The spray units 121a of a deposition source evaporating apparatus 100 may be substantially a mirror image of the spray units 121a of the other deposition source evaporating apparatus 100. The spray units 121a are more densely arranged at two end portions of the combined apparatus (corresponding to two edge portions of the large target substrate 300) than in a middle portion of the combined apparatus (corresponding to the middle portion of the target substrate 300). The deposition source evaporating apparatuses 100 may be attached to each other and may directly contact each other.

As discussed, embodiments can provide a deposition source evaporating apparatus comprising: a first crucible set for accommodating a deposition source; a spray unit positioned on the first crucible set; a heater positioned in the first crucible set for heating the first crucible set to evaporate the deposition source through the spray unit; and a heat radiation preventing plate surrounding the spray unit for blocking heat radiation at a side of the first crucible set, wherein at least one of the first crucible set and the heat radiation preventing plate comprises a carbon fiber composite material.

The heat radiation may be at a side of the first crucible set arranged to face a deposition target of the deposition source evaporating apparatus.

The heat radiation preventing plate may comprise a through hole formed at a position corresponding to the spray unit, and the spray unit may provide deposition gas to a source through the through hole formed in the heat radiation preventing plate. The heat radiation preventing plate may be a side of the first crucible set facing the source.

The heat radiation preventing plate may be a single body (or monolithic body) formed of a carbon fiber composite material.

The first crucible set may comprise an inner crucible for accommodating the deposition source, an outer crucible accommodating the inner crucible and configured to transfer heat from the heater to the inner crucible, a housing accommodating the outer crucible and the heater, a cooling jacket accommodating the housing, and a coolant circulation unit positioned on the cooling jacket, and wherein at least one of the inner crucible wherein at least one of the inner crucible, the outer crucible, and the housing comprises the carbon fiber composite material.

The crucible set may further comprise a heat radiation plate positioned on an internal wall of the housing, and the heat radiation plate may comprise the carbon fiber composite material.

The inner crucible, the outer crucible, the heat radiation plate, the housing, and a frame supporting the heat radiation plate inside the housing may all be formed as a single body using the above-described carbon fiber composite material.

Embodiments can provide a method of manufacturing a deposition source evaporating apparatus comprising: preparing a first crucible set for accommodating a deposition source and a spray unit positioned on the first crucible set; installing a heater in the first crucible set for heating the first crucible set to evaporate the deposition source through the spray unit; and installing a heat radiation preventing plate surrounding the spray unit for blocking heat radiation at a side of the first crucible set, wherein at least one of the first crucible set and the heat radiation preventing plate comprises a carbon fiber composite material.

According to embodiments, a deposition operation may also be performed smoothly and reliably for a long time, a life span of the components may be prolonged, and both the workability and the deposition quality may be optimized. One or more of the members of the deposition source evaporation apparatus may be formed as one continuous body (or monolithic body) instead of as several small discrete portions. Advantageously, the manufacturing and management of the apparatus may be substantially convenient.

Embodiments described herein should be considered in an illustrative sense and not for purposes of limitation. Descriptions of features or aspects each embodiment may be applicable for other embodiments.

While one or more embodiments have been described with reference to the figures, various changes in form and details may be made without departing from the scope defined by the following claims.

## Claims

1. A deposition source evaporating apparatus comprising:
a first crucible set for accommodating a deposition source;
a spray unit positioned on the first crucible set;
a heater positioned in the first crucible set for heating the first crucible set to evaporate the deposition source through the spray unit; and
a heat radiation preventing plate surrounding the spray unit for blocking heat radiation at a side of the first crucible set,
wherein at least one of the first crucible set and the heat radiation preventing plate comprises a carbon fiber composite material.

2. The apparatus of claim 1, wherein the carbon fiber composite material comprises a carbon fiber granule and a first carbon-based resin.

3. The apparatus of claim 2, wherein the carbon fiber granule comprises at least one of a carbon fiber fragment and carbon fiber powder.

4. The apparatus of claim 2 or 3, wherein an internal gap of the carbon fiber composite material is filled with a second carbon-based resin.

5. The apparatus of any one of claims 1 to 4, wherein the heat radiation preventing plate is a single body, and wherein a length of the single body is greater than a half of the length of the apparatus.

6. The apparatus of any one of claims 1 to 5,
wherein the first crucible set comprises an inner crucible for accommodating the deposition source, an outer crucible accommodating the inner crucible and configured to transfer heat from the heater to the inner crucible, a housing accommodating the outer crucible and the heater, a cooling jacket accommodating the housing, and a coolant circulation unit positioned on the cooling jacket, and
wherein at least one of the inner crucible, the outer crucible, and the housing comprises the carbon fiber composite material.

7. The apparatus of claim 6, wherein the inner crucible is a single body having a single accommodating space, and wherein a length of the single accommodating space is greater than a half of the length of the apparatus.

8. The apparatus of claim 6 or 7, wherein the crucible set further comprises a heat radiation plate positioned on an internal wall of the housing, and wherein the heat radiation plate comprises the carbon fiber composite material.

9. The apparatus of claim 8, wherein the housing, the heat radiation plate, and the outer crucible are an integral body of a same material.

10. The apparatus of any one of claims 1 to 9, wherein the heat radiation is at a side of the first crucible set arranged to face a deposition target.

11. The apparatus of any one of claims 1 to 10, wherein the heat radiation preventing plate comprises a through hole formed at a position corresponding to the spray unit.

12. The apparatus of any one of claims 1 to 11, comprising:
a first plurality of spray units positioned on the first crucible set and including the spray unit;
a second crucible set; and
a second plurality of spray units positioned on the second crucible set and being a mirror image of the first plurality of spray units.
